# EUROPEAN PATENT APPLICATION

(11) **EP 2 590 210 A2**
(43) Date of publication of application: **08.05.2013**
(21) Application number: 11195172.9
(22) Date of filing: 22.12.2011
(51) Int. Cl.: H01L 23/36, H01L 23/373, H01L 21/48

(54) **Heat dissipating device and manufacture method thereof**

(30) Priority: 04.11.2011 TW 100140441
(71) Applicant: Most Energy Corporation, Luzhu Township, Taoyuan County (TW)
(72) Inventor: Lai, Ming-Hsiung, 302 Zhubei City, Hsinchu County (TW); Jiang, Yu-Hsiang, 235 Zhonge Dist., New Taipei City (TW); Chen, You-Chi, 406 Beitun Dist., Taichung City (TW)
(74) Representative: 2K Patentanwälte Blasberg Kewitz & Reichel

(57) **Abstract**

A heat dissipating device includes a base and a plurality of heat dissipating layers. The base has a first surface and a second surface which are opposite to each other. The heat dissipating layers are formed on the first surface of the base in sequence. Each heat dissipating layer has at least one heat dissipating structure, which includes a heat storage/dissipation area and a heat conductive area. The heat storage/dissipation area surrounds the heat conductive area, and a gap is configured between the heat storage/dissipation area and the heat conductive area. The heat storage/dissipation areas of two adjacent heat dissipating layers contact with each other, while the heat conductive areas of two adjacent heat dissipating layers contact with each other.

## Description

### BACKGROUND OF THE INVENTION

### Field of Invention

The present invention relates to a heat dissipating device and a manufacturing method thereof.

### Related Art

Regarding to the design and development of electronic apparatus, to improve their performance is one of the most important considerations. The electronic components in the electronic apparatus, which operates in high speed, usually generate a lot of heat. However, the high-temperature operation environment can suffer the characteristics of the electronic components, and moreover, the extremely high temperature may cause the permanent damage of the electronic components. Accordingly, the proper heat dissipating device has become an important and indispensable component in the electronic apparatus.

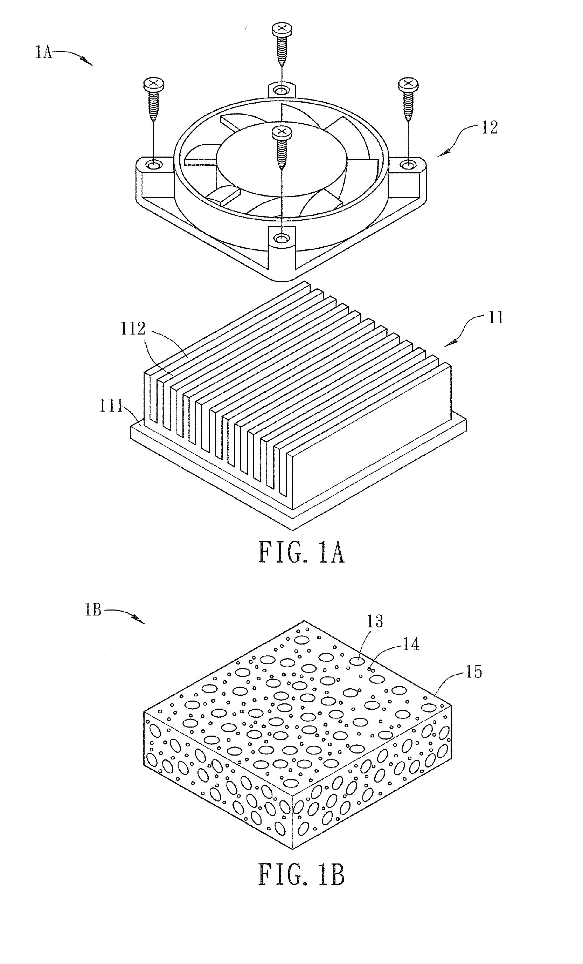

As shown in FIG. 1A, a conventional heat dissipating device 1A includes a heat sink 11 and a fan 12. The heat sink 11 has a base 111 and a plurality of fins 112. The base 111 of the heat sink 11 is attached to the component to be cooled down, and the fan 12 is locked on the fins 112 of the heat sink 11. When the heat generated by the component is conducted to the heat sink 11, it is transferred from the bottom of the base 111 to each of the fins 112. Then, the fan 12 blows the fins 112 to dissipate the generated heat.

However, in the conventional heat dissipating device 1A, since the hub of the fan 12 can not generate the airflow, the central area of the heat sink 11 has poorer heat-dissipating efficiency than the periphery area thereof. In other words, the conventional heat-dissipating device 1A can not provide a uniformly heat-dissipating effect. Besides, the dimension of the conventional heat dissipating device 1A is large, so it can not satisfy the requirement of more compact and smaller electronic products.

In addition, since graphite has excellent heat-dissipating property and aluminum has excellent thermal conductivity, they have been both used in the heat dissipating device. As shown in FIG. 1B, another conventional heat dissipating device 1B includes a plurality of graphite particles 13 and a plurality of aluminum particles 14, which are mixed within an adhesive 15 and then shaped by thermal roller. The graphite particles 13 can provide good heat-dissipating ability on the X-Y plane, but it has poor heat transmission along the Z axis (vertical direction). Accordingly, the portions far away from the heat source in the vertical direction, the heat-dissipating function becomes very poor. To increase the thickness or to add more graphite powder can still not overcome the inherent limitation of the graphite. Besides, the aluminum particles 14 are added into the heat dissipating device 1B, and the graphite particles 13 and the aluminum particles 14 are simply mixed in the heat dissipating device 1B only. Therefore, the heat dissipating device 1B still can not dissipate the heat uniformly and thus can not improve the heat dissipation efficiently.

Therefore, it is an important subject of the present invention to provide a heat dissipating device and a manufacturing method thereof that can uniformly dissipate the heat so as to improve the heat-dissipating effect and can remain the simple and fast manufacturing processes.

### SUMMARY OF THE INVENTION

In view of the foregoing subject, an object of the present invention is to provide a heat dissipating device and a manufacturing method thereof that can uniformly dissipate the heat so as to improve the heat-dissipating effect and can remain the simple and fast manufacturing processes.

To achieve the above object, the present invention discloses a heat dissipating device includes a base and a plurality of heat dissipating layers. The base has a first surface and a second surface which are opposite to each other. The heat dissipating layers are formed on the first surface of the base in sequence. Each heat dissipating layer has at least one heat dissipating structure, which includes a heat storage/dissipation area and a heat conductive area. The heat storage/dissipation area surrounds the heat conductive area, and a gap is configured between the heat storage/dissipation area and the heat conductive area. The heat storage/dissipation areas of two adjacent heat dissipating layers contact with each other, while the heat conductive areas of two adjacent heat dissipating layers contact with each other.

In one embodiment of the present invention, the base is made of a metal comprising copper, aluminum, gold, silver, tungsten, or their alloys.

In one embodiment of the present invention, the thickness of the base is between 100µm and 1000µm.

In one embodiment of the present invention, the heat storage-dissipation area comprises a plurality of non-metal particles. The non-metal particles are graphite particles, the purity of the graphite particle is between 97% and 99.9%, and the diameter of the graphite particle is between 500µm and 3000µm.

In one embodiment of the present invention, the heat conductive area comprises a plurality of metal particles, which comprises copper, aluminum, gold, silver, tungsten, or their alloys.

In one embodiment of the present invention, the ratio of the size of the heat conductive area to the size of the heat storage/dissipation area is between 1:1.25 and 1:2.5.

In one embodiment of the present invention, the heat dissipating device further includes an adhesive layer and a protection layer. The adhesive layer is formed on the second surface of the base, and the protection layer is formed on the heat dissipating layers.

In one embodiment of the present invention, the ratio of the gap to the circumference of the heat storage/dissipation area is between 0.01:1 and 0.15:1.

In addition, the present invention also discloses a manufacturing method of a heat dissipating device. The manufacturing method includes the following steps of: providing a base, and printing a plurality of heat dissipating layers on a first surface of the base in sequence. Each of the heat dissipating layers has at least one heat dissipating structure. The heat dissipating structure includes a heat storage/dissipation area and a heat conductive area, and the heat storage/dissipation area surrounds the heat conductive area. A gap is configured between the heat storage/dissipation area and the heat conductive area. The heat storage/dissipation areas of adjacent two of the heat dissipating layers contact with each other, while the heat conductive areas of adjacent two of the heat dissipating layers contact with each other.

In one embodiment of the present invention, the heat dissipating layers are formed on the first surface of the base by screen printing using multiple printing method or overprinting method.

In one embodiment of the present invention, the manufacturing method further includes the following steps of: forming an adhesive layer on the second surface of the base; and forming a protection layer on the heat dissipating layers.

As mentioned above, the heat dissipating device of the present invention includes a plurality of heat dissipating layers formed on the base in sequence by printing. In the heat dissipating layer, the heat storage/dissipation area surrounds the heat conductive area, and a gap is configured between the heat storage/dissipation area and the heat conductive area. Besides, the heat storage/dissipation areas of two adjacent heat dissipating layers contact with each other, while the heat conductive areas of two adjacent heat dissipating layers contact with each other. According to this configuration, the vertical thermal transmission can be improved, so that the heat generated from the heat source can be conducted to the heat storage/dissipation areas of every heat dissipating layer. Therefore, the heat can be uniformly dissipated so as to improve the heat-dissipating effect and still remain the simple and fast manufacturing processes.

### BRIEF DESCRIPTION OF THE DRAWINGS

The invention will become more fully understood from the detailed description and accompanying drawings, which are given for illustration only, and thus are not limitative of the present invention, and wherein:

FIG. 1A is a schematic diagram showing a conventional heat dissipating device;

FIG. 1B is a schematic diagram showing another conventional heat dissipating device;

FIGS. 2A and 2B are schematic diagram showing a heat dissipating device according to a preferred embodiment of the present invention;

FIG. 3 is a schematic diagram showing a heat dissipating structure of the heat dissipating device according to the preferred embodiment of the present invention;

FIGS. 4A to 4F are top views of different aspects of the heat storage/dissipation area and heat conductive area according to the preferred embodiment of the present invention;

FIG. 5 is a schematic diagram showing another heat dissipating device according to the preferred embodiment of the present invention; and

FIG. 6 is a flow chart of a manufacturing method of a heat dissipating device according to the preferred embodiment of the present invention.

### DETAILED DESCRIPTION OF THE INVENTION

The present invention will be apparent from the following detailed description, which proceeds with reference to the accompanying drawings, wherein the same references relate to the same elements.

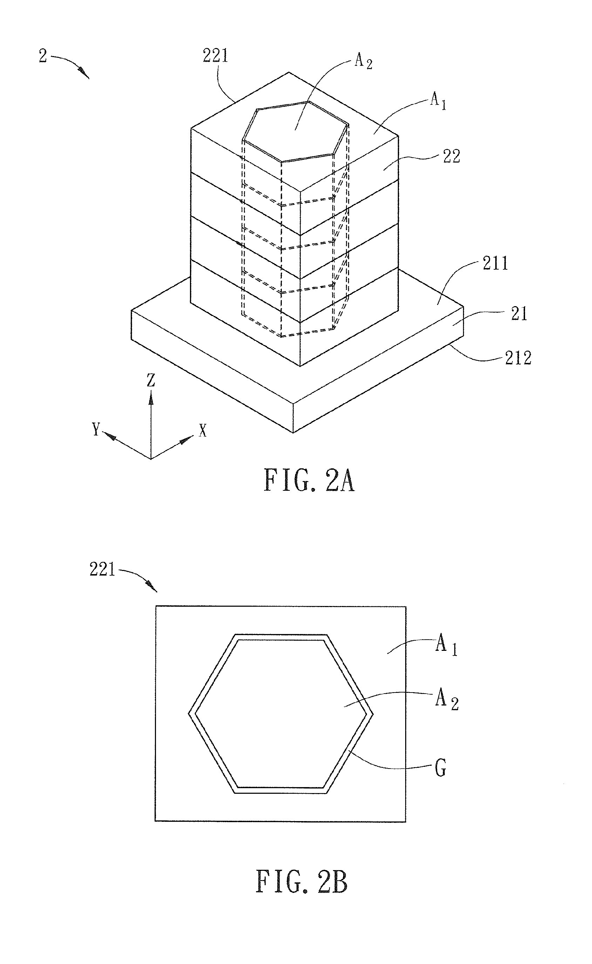

FIGS. 2A and 2B are schematic diagram showing a heat dissipating device 2 according to a preferred embodiment of the present invention. Referring to FIGS. 2A and 2B, the heat dissipating device 2 includes a base 21 and four heat dissipating layers 22. To be noted, the number of the heat dissipating layers 22 can be four or other numbers. In practice, the heat dissipating device 2 can be applied to power device, display card, motherboard, lamp, other electronic devices or other electronic products, for dissipating the generated heat.

The base 21 has a first surface 211 and a second surface 212, which are opposite to each other. In practice, the base 21 can be made of a metal including copper, aluminum, gold, silver, tungsten, or their alloys. Besides, the area and thickness of the base 21 can be adjustable according to the size and generated heat of the heat source. Preferably, the thickness of the base 21 is between 100µm and 1000µm.

The heat dissipating layers 22 are formed on the first surface 211 of the base 21 in sequence. In other words, the heat dissipating layers 22 are stacked on the first surface 211. Each heat dissipating layer 22 includes a heat dissipating structure 221. As shown in FIG. 2B, the heat dissipating structure 221 includes a heat storage/dissipation area A₁ and a heat conductive area A₂. The heat storage/dissipation area A₁ surrounds the heat conductive area A₂, and a gap G is configured between the heat storage/dissipation area A₁ and the heat conductive area A₂.

In addition, as shown in FIG. 2A, the heat storage/dissipation areas A₁ of two adjacent heat dissipating layers 22 are vertically contact with each other, while the heat conductive areas A₂ of two adjacent heat dissipating layers are vertically contact with each other. To be noted, the heat storage/dissipation areas A₁ or the heat conductive areas A₂ can contact partially or entirely.

In this embodiment, the heat dissipating device 2 includes four heat dissipating layers 22, and each heat dissipating layer 22 includes a heat dissipating structure 221. To be noted, depending on the requirement and design of the product, the heat dissipating device 2 may include other numbers of heat dissipating layers 22, and each heat dissipating layer 22 may include one or more heat dissipating structures 221. Preferably, the heat dissipating device 2 includes 3-15 heat dissipating layers 22, and each heat dissipating layer 22 includes 50-750 heat dissipating structures 221 per square inch.

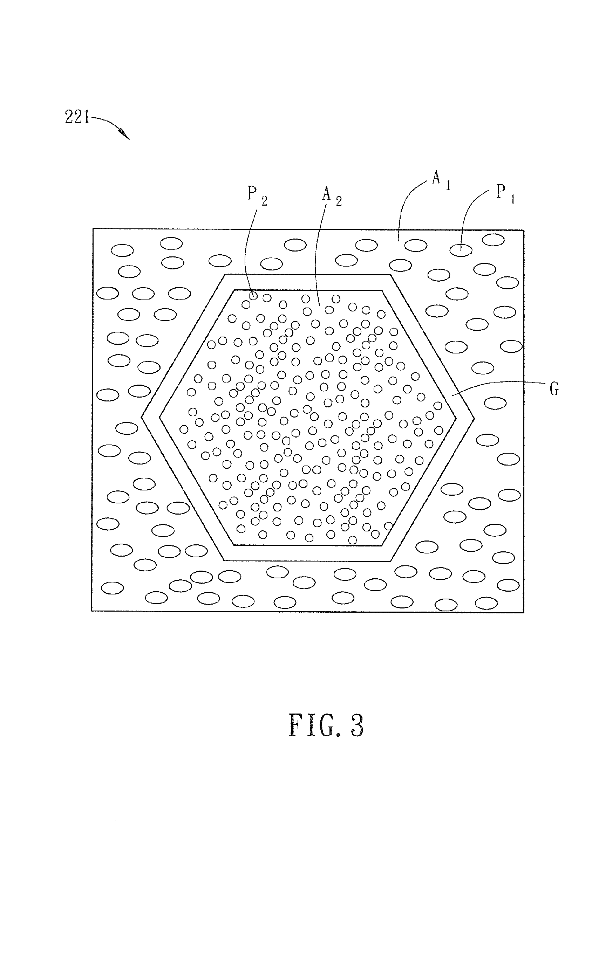

The heat dissipating structure 221 will be further described hereinafter with reference to FIG. 3. The heat storage/dissipation area A₁ of the heat dissipating structure 221 includes a plurality of non-metal particles P₁ and a polymer gel. The non-metal particles P₁ can be graphite particles, and the polymer gel can be a light-cured gel or a thermosetting gel. In this embodiment, the polymer gel is PMMA (polymethly methacrylate).

In practice, the purity of the graphite particle is between 97% and 99.9%, and the diameter of the graphite particle is between 500µm and 3000µm. Since the graphite has excellent thermal conductivity, especially on the plane composed of X-axis and Y-axis, the heat storage/dissipation area A₁ containing the graphite particles can provide high-performance thermal transmission along the horizontal direction of the heat dissipating layer 22.

The heat conductive area A₂ of the heat dissipating structure 221 includes a plurality of metal particles P₂ and a polymer gel. The metal particles P₂ can include copper, aluminum, gold, silver, tungsten, or their alloys, and the polymer gel can be a light-cured gel or a thermosetting gel. In this embodiment, the polymer gel is PMMA (polymethly methacrylate).

Since the metal particles P₂ has better thermal conductivity in the vertical direction (Z-axis), the heat conductive area A₂ containing the metal particles P₂ can provide high-performance thermal transmission along the vertical direction of the heat dissipating layer 22. In practice, the ratio of the size of the heat conductive area A₂ to the size of the heat storage/dissipation area A₁ is between 1:1.25 and 1:2.5. In addition, the weight percentages of the non-metal particles P₁ and the metal particles P₂ can be modified according to the actual requirement.

The gap G of the heat dissipating structure 221 is configured as the buffer for the thermal expansion of the heat storage/dissipation area A₁ and the heat conductive area A₂, so that the heat storage/dissipation area A₁ and the heat conductive area A₂ can closely attach to each other as the heat dissipating structure 221 is heated. This configuration can enhance the thermal conduction and heat dissipation of the heat dissipating structure 221. Preferably, the ratio of the gap G to the circumference of the heat storage/dissipation area A₁ is between 0.01:1 and 0.15:1. Alternatively, since the expansion of different materials under the heating environment may vary, the size of the gap G is preferably modified with respect to different materials.

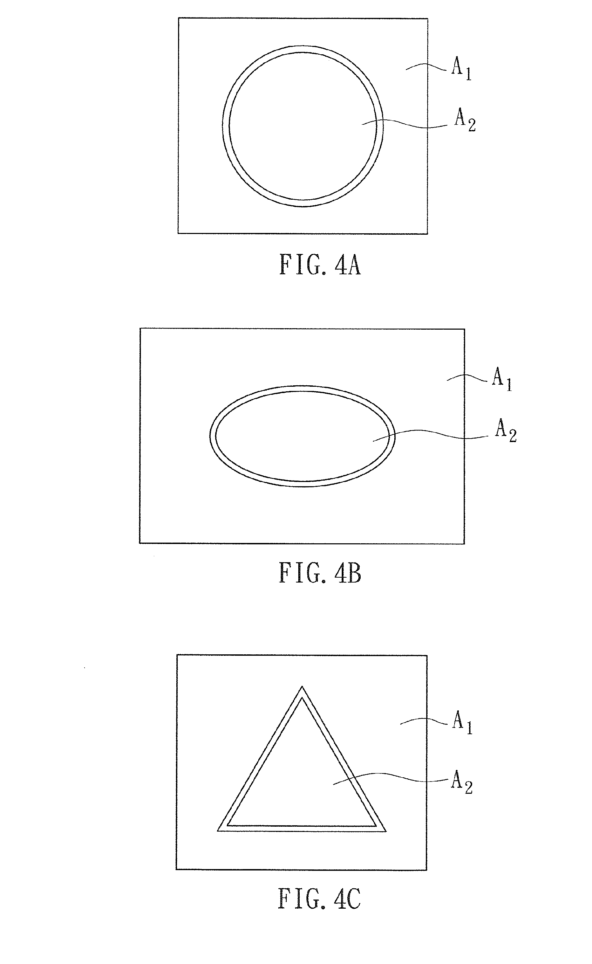

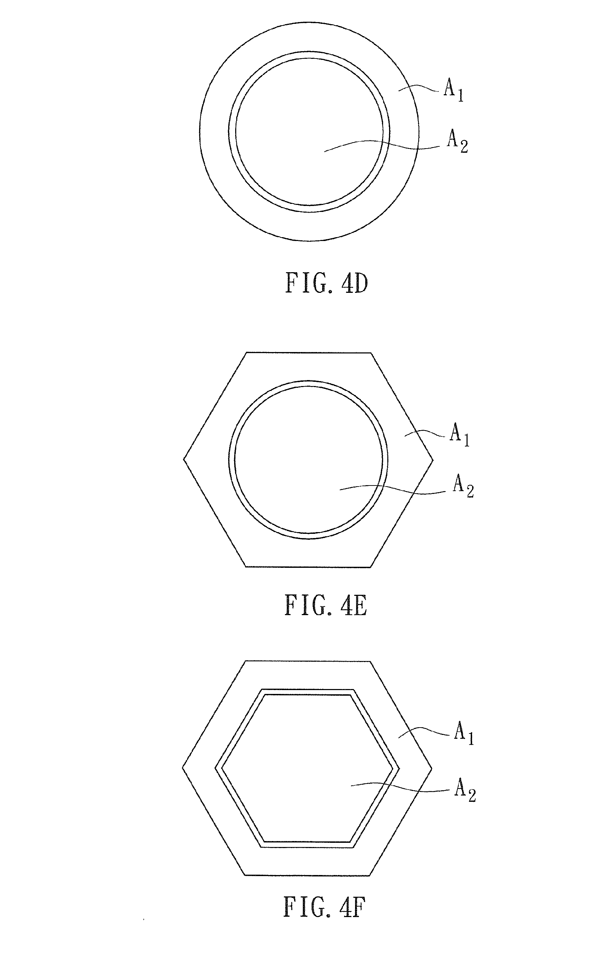

From the top view, the shapes of the heat storage/dissipation area A₁ and the heat conductive area A₂ can have different aspects, which will be described hereinafter with reference to FIGS. 4A to 4F.

In FIG. 4A, the top view of the heat storage/dissipation area A₁ shows a quadrangle with equivalent sides, and the top view of the heat conductive area A₂ shows a circle. In FIG. 4B, the top view of the heat storage/dissipation area A₁ shows a quadrangle with non-equivalent sides, and the top view of the heat conductive area A₂ shows an ellipse. In FIG. 4C, the top view of the heat storage/dissipation area A₁ shows a quadrangle with non-equivalent sides, and the top view of the heat conductive area A₂ shows a triangle. In FIG. 4D, the top views of the heat storage/dissipation area A₁ and the heat conductive area A₂ show circles. In FIG 4E, the top view of the heat storage/dissipation area A₁ shows a hexagon with equivalent sides, and the top view of the heat conductive area A₂ shows a circle. In FIG 4D, the top views of the heat storage/dissipation area A₁ and the heat conductive area A₂ show hexagons with equivalent sides.

To be noted, the above-mentioned aspects of the heat storage/dissipation area A₁ and the heat conductive area A₂ are for illustrations only and are not to limit the scope of the present invention. In brief, the shape (from the top view) of the heat storage/dissipation area A₁ and the heat conductive area A₂ can be circle, ellipse, polygon with equivalent sides, or polygon with non-equivalent sides. Besides, the shapes of the heat storage/dissipation area A₁ and the heat conductive area A₂ can be the same or different. Herein, the polygon includes, for example, 3 to 10 sides.

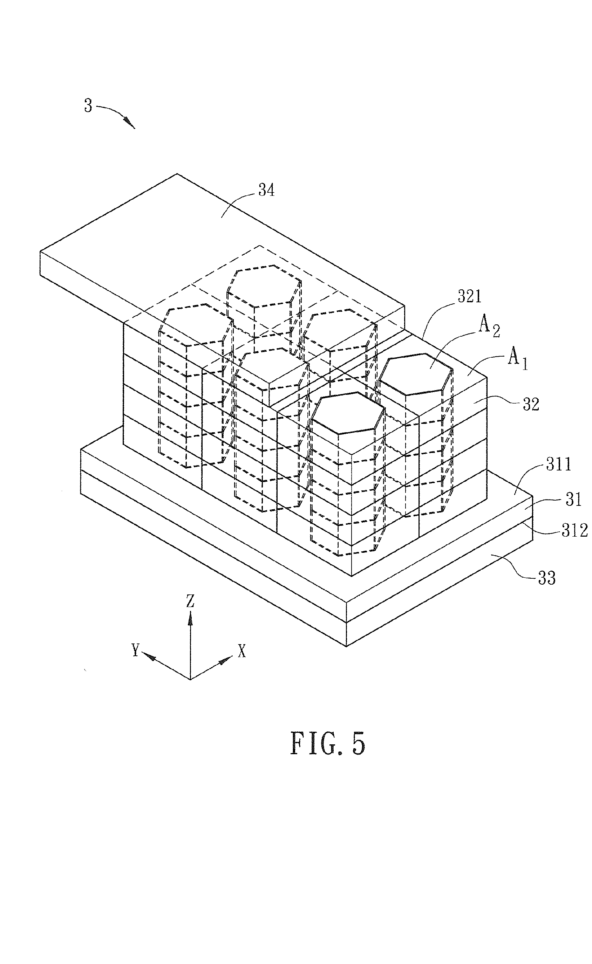

FIG 5 is a schematic diagram showing another heat dissipating device 3 according to the preferred embodiment of the present invention. Referring to FIG 5, the difference between the heat dissipating devices 2 and 3 is in that the heat dissipating device 3 further includes an adhesive layer 33 and a protection layer 34. In this embodiment, the heat dissipating layer 32 of the heat dissipating device 3 includes six heat dissipating structures 321.

In this embodiment, the adhesive layer 33 is formed on the second surface 312 of the base 31. For example, the adhesive layer 33 is a thermal-conductive pressure-sensitive adhesive, which is covered by a separating paper. In addition, the heat dissipating layers 32 are formed on the first surface 311 of the base 31 in sequence, and the protection layer 34 is formed on the heat dissipating layers 32 for improving the structural strength of the heat dissipating device 3. Moreover, the material of the protection layer 34 may be selected from the same material of the heat storage/dissipation area A₁ and the heat conductive area A₂ of the heat dissipating structure 321.

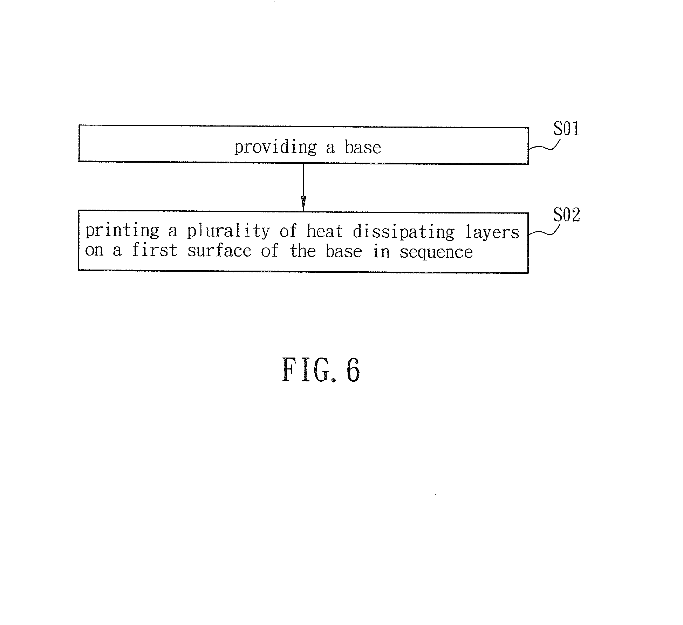

The manufacturing method of the above-mentioned heat dissipating device 2 according to the preferred embodiment of the present invention will be described hereinafter with reference to the flow chart in FIG. 6 in view of FIG. 2A. The manufacturing method includes the following steps S01 to S02.

The step S01 is to provide a base 21. In this embodiment, the base 21 is made of a metal including copper, aluminum, gold, silver, tungsten, or their alloys. Besides, the area and thickness of the base 21 can be adjustable according to the size and generated heat of the heat source. Preferably, the thickness of the base 21 is between 100µm and 1000µm.

The step S02 is to print a plurality of heat dissipating layers 22 on a first surface 211 of the base 21 in sequence. In this embodiment, each of the heat dissipating layers 22 has a heat dissipating structure 221, which includes a heat storage/dissipation area A₁ and a heat conductive area A₂. The heat storage/dissipation area A₁ surrounds the heat conductive area A₂, and a gap is configured between the heat storage/dissipation area A₁ and the heat conductive area A₂. The heat storage/dissipation areas A₁ of two adjacent heat dissipating layers 22 contact with each other, while the heat conductive areas A₂ of two adjacent heat dissipating layers 22 contact with each other.

In practice, the heat dissipating layers 22 are formed on the first surface 211 of the base 21 by screen printing using multiple printing method or overprinting method. Preferably, the number of the heat dissipating layers 22 is from 3 to 15.

Similarly, the manufacturing method of FIG 6 can also be applied to manufacture the above-mentioned heat dissipating device 3 (see FIG 5). In this embodiment, the manufacturing method further includes the following steps of forming an adhesive layer 33 on the second surface 312 of the base 31, and forming a protection layer 34 on the heat dissipating layers 32. The adhesive layer 33 is, for example, a thermal-conductive pressure-sensitive adhesive, for closely attaching to the object (e.g. power device, display card, motherboard, lamp, other electronic devices or other electronic products) to be cooled down. Besides, the adhesive layer 33 is covered by a separating paper. The protection layer 34 is configured to improve the structural strength of the heat dissipating device 3. Moreover, the material of the protection layer 34 may be selected from the same material of the heat storage/dissipation area A₁ and the heat conductive area A₂ of the heat dissipating structure 321.

As mentioned above, the heat storage/dissipation area A₁, which has larger surface contacting the base 21, is used for storing heat and dissipating heat, and the heat conductive area A₂, which is made in lamination, is perpendicular to the base 21, so that it can transmit redundant heat of the base 21 in the Z-axis to other heat storage/dissipation area A₁ farer away from the base 21. Besides, the heat storage/dissipation area A₁ with excellent heat dissipating ability on the plane of X-axis and Y-axis can temporarily store the absorbed heat in the lattice structure itself, and then dissipate the redundant heat gradually depending on the physical property of the non-metal particles P₁.

In summary, the heat dissipating device of the present invention includes a plurality of heat dissipating layers formed on the base in sequence by printing. In the heat dissipating layer, the heat storage/dissipation area surrounds the heat conductive area, and a gap is configured between the heat storage/dissipation area and the heat conductive area. Besides, the heat storage/dissipation areas of two adjacent heat dissipating layers contact with each other, while the heat conductive areas of two adjacent heat dissipating layers contact with each other. According to this configuration, the vertical thermal transmission (Z-axis) can be improved, so that the heat generated from the heat source can be conducted to the heat storage/dissipation areas of every heat dissipating layer. Therefore, the heat can be uniformly dissipated so as to improve the heat-dissipating effect and still remain the simple and fast manufacturing processes.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A heat dissipating device (2; 3), comprising:
a base (21; 31) having a first surface (211; 311) and a second surface (212; 312)
opposite to each other; and
a plurality of heat dissipating layers (22; 32) formed on the first surface of the
base in sequence;
wherein, each of the heat dissipating layers has at least one heat dissipating structure (221), the heat dissipating structure comprises a heat storage/dissipation area (A₁) and a heat conductive area (A₂), the heat storage/dissipation area surrounds the heat conductive area, a gap (G) is configured or formed between the heat storage/dissipation area (A₁) and the heat conductive area (A₂), and the heat storage/dissipation areas of adjacent two of the heat dissipating layers contact with each other, while the heat conductive areas of adjacent two of the heat dissipating layers contact with each other.

2. The heat dissipating device of claim 1, wherein the base (21; 31) is made of a metal comprising copper, aluminum, gold, silver, tungsten, or their alloys.

3. The heat dissipating device of claim 1 or 2, wherein the thickness of the base (21; 31) is between 100 µm and 1000µm.

4. The heat dissipating device of any of the preceding claims, wherein the heat storage-dissipation area (A₁) comprises a plurality of non-metal particles.

5. The heat dissipating device of claim 4, wherein the non-metal particles are graphite particles, the purity of the graphite particle is between 97% and 99.9%, and the diameter of the graphite particle is between 500µm and 3000µm.

6. The heat dissipating device of any of the preceding claims, wherein the heat conductive area (A₂) comprises a plurality of metal particles.

7. The heat dissipating device of claim 6, wherein the metal particles comprises copper, aluminum, gold, silver, tungsten, or their alloys.

8. The heat dissipating device of any of the preceding claims, wherein the ratio of the size of the heat conductive area to the size of the heat storage/dissipation area is between 1:1.25 and 1:2.5.

9. The heat dissipating device of any of the preceding claims, further comprising:
an adhesive layer (33) formed on the second surface (312) of the base (3); and
a protection layer (34) formed on the heat dissipating layers (32).

10. The heat dissipating device of adhesive, wherein the ratio of the gap to the circumference of the heat storage/dissipation area is between 0.01:1 and 0.15:1.

11. A manufacturing method of a heat dissipating device, in particular for manufacturing a heat dissipating device (2; 3) according to any of the preceding claims, comprising steps of:
providing a base (21; 31); and
printing a plurality of heat dissipating layers (22; 32) on a first surface (211; 311) of the base in sequence;
wherein each of the heat dissipating layers has at least one heat dissipating structure, the heat dissipating structure comprises a heat storage/dissipation area and a heat conductive area, the heat storage/dissipation area surrounds the heat conductive area, a gap is configured between the heat storage/dissipation area and the heat conductive area, and the heat storage/dissipation areas of adjacent two of the heat dissipating layers contact with each other, while the heat conductive areas of adjacent two of the heat dissipating layers contact with each other.

12. The manufacturing method of claim 11, wherein the heat dissipating layers are formed on the first surface of the base by screen printing using multiple printing method or overprinting method.

13. The manufacturing method of claim 11 or 12, further comprising steps of:
forming an adhesive layer on the second surface of the base; and
forming a protection layer on the heat dissipating layers.
